# EUROPEAN PATENT APPLICATION

(11) **EP 1 469 529 A2**
(43) Date of publication of application: **20.10.2004**
(21) Application number: 04101344.2
(22) Date of filing: 01.04.2004
(51) Int. Cl.: H01L 33/00

(54) **Alternating current light emitting device**

(30) Priority: 16.04.2003 US 417735
(71) Applicant: Lumileds Lighting U.S., LLC, San Jose, California 95131 (US)
(72) Inventor: Martin, Paul, S. c/o Lumileds Lighting, U.S., LLC, San Jose, CA 95131 (US)
(74) Representative: van der Veer, Johannis Leendert

(57) **Abstract**

A plurality of semiconductor light emitting diodes formed on a single substrate are connected in series for use with an alternating current source. In one embodiment, the series array of light emitting diodes is directly connected to an alternating current source. In other embodiments, the series array of semiconductor light emitting diodes is mounted on a submount with integrated rectifying and filtering circuitry. The submount may be, for example, a silicon integrated circuit. In some embodiments a wavelength converting material is provided over the semiconductor light emitting diodes such that light emitted by the light emitting diodes and light emitted by the wavelength converting material mix to produce white light.

## Description

The present invention relates to monolithic arrays of semiconductor light emitting devices powered by alternating current sources.

Wojnarowski et al., U.S. Patent 6,412,971, teach an array of separate, individual semiconductor light emitting diodes (LEDs) mounted on a conventional light bulb base for insertion into a residential 120 volt alternating current socket. Wojnarowski et al.'s devices include a rectifier and filter to provide direct current. Direct current provides a constant voltage and current to the array of LEDs, thus the LEDs are constantly on when the array is connected to the alternating current source, eliminating any visible flickering that may have occurred had unfiltered alternating current been used to power the array. Wojnarowski et al.'s devices are bulky and difficult to build and package due to the large number of separate LEDs used and due to the external filtering and rectifying circuitry. The filtering and rectifying circuitry also use power, create heat, and add cost.

In accordance with embodiments of the invention, a plurality of LEDs formed on a single substrate are connected in series for use with an alternating current source. In one embodiment, the plurality of LEDs are directly connected to an unfiltered and unrectified alternating current source. In other embodiments, the LEDs are mounted on a submount with integrated rectifying and filtering circuitry. The submount may be, for example, a silicon integrated circuit. In some embodiments a wavelength converting material is provided over the LEDs such that light emitted by the LEDs and light emitted by the wavelength converting material mix to produce light with a wavelength distribution different from that emitted by the LEDs.

Devices without external LED electrical drivers (or with rectifying and filtering circuitry integrated in the submount) offer the advantages of being small and simple to build and package. Such devices may also have reliability and cost advantages.

### BRIEF DESCRIPTION OF THE DRAWINGS:

Fig. 1A is a plan view of a monolithic array of electrically isolated LEDs.
Fig. 1B is a plan view of a single LED in the array shown in Fig. 1A.
Fig. 2 is a cross-sectional view of the device illustrated in Fig. 1B.
Fig. 3 illustrates a monolithic array of LEDs mounted on a submount.
Figs. 4 and 5 are circuit diagrams of different embodiments of the device of Fig. 3.
Fig. 6 illustrates an embodiment of the invention incorporating a zener diode.
Fig. 7 is an exploded view of a packaged light emitting device.
Fig. 8 is a cross section of a portion of a monolithic array of LEDs mounted on a submount.
Figs. 9 and 10 illustrate packaged devices.

In accordance with embodiments of the present invention, semiconductor light emitting devices such as light emitting diodes are arranged in monolithic arrays suitable for use with high voltage power sources include those using alternating current. "High voltage" refers to a voltage greater than 10 times the forward voltage of a single LED. For example, some current III-nitride devices operate at a forward voltage of about 3.5 V at a current density of about 50 A/cm². Such devices usually fail at current densities greater than 150 A/cm². If a single such device were connected to a 120 RMS V alternating current circuit, the peak voltage of about 180 V would far exceed the maximum operating current density. Accordingly, in some embodiments, multiple LEDs are connected in series in order to achieve an appropriate voltage drop and current density for each device when connected to a high voltage power source.

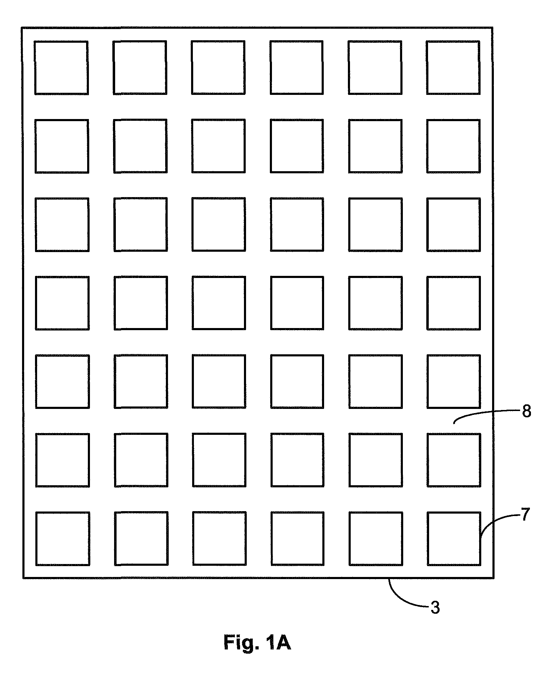

Fig. 1A is a plan view of a monolithic array of LEDs for use in an alternating current device. An array of individual LEDs 7 are formed on a single substrate 3. The individual LEDs in the array are electrically isolated from each other by, for example, trenches 8 etched between the devices down to substrate 3 or to an insulating layer such as an undoped semiconductor layer.

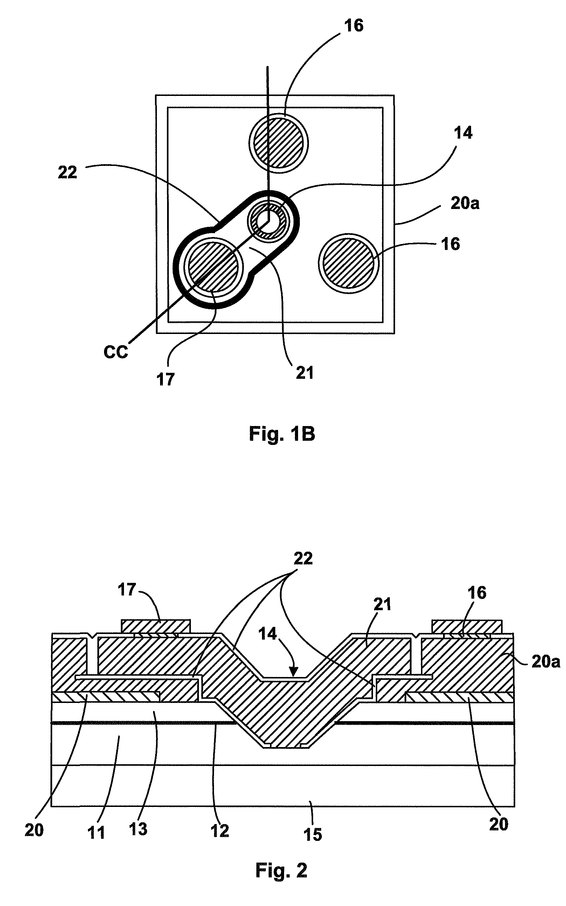

Fig. 1B is a plan view of an example of a single small junction III-nitride LED 7 (i.e., an area less than approximately one square millimeter) formed in the monolithic device illustrated in Fig. 1A. In one embodiment, the device in Fig. 1B has an area greater than 300 microns by 300 microns. Fig. 2 is a cross section of the device shown in Fig. 1B, taken along axis CC. As illustrated in Fig. 2, the device includes an n-type region 11, an active region 12, and a p-type region 13 formed over a substrate 15. Each of the n-type region 11, the active region 12, and the p-type region 13 may be, for example, III-nitride semiconductor layers, and each region may contain multiple layers with the same or different characteristics. The substrate may be, for example, sapphire, GaP, Si, or SiC.

The device shown in Figs. 1B and 2 has a single via 14 etched down to n-type layer 11. An n-contact 21 is deposited in via 14. N-via 14 is located at the center of the device to provide uniformity of current and light emission. A highly reflective p-contact 20 is deposited on p-type layer 13. A thick p-metal layer 20a is deposited over reflective p-contact 20. N-contact 21 is separated from the p-metal layers 20, and 20a by one or more dielectric layers 22. A p-submount connection 16 connects to p-metal layer 20a, and an n-submount connection 17 connects to n-metal layer 21, for connecting the device to a submount. Interconnects 16 and 17 may be, for example, solder bumps.

As illustrated in Fig. 1B, the device is connected to a submount by p-submount connections 16 and n-submount connection 17. N-submount connection 17 may be located anywhere within n-contact region 21 (surrounded by insulating layer 22) and need not be located directly over via 14. Similarly, p-submount connections 16 may be located anywhere on p-metal layer 20a. As a result, the connection of the device to a submount is not limited by the shape or placement of p-contact 20a and n-contact 21.

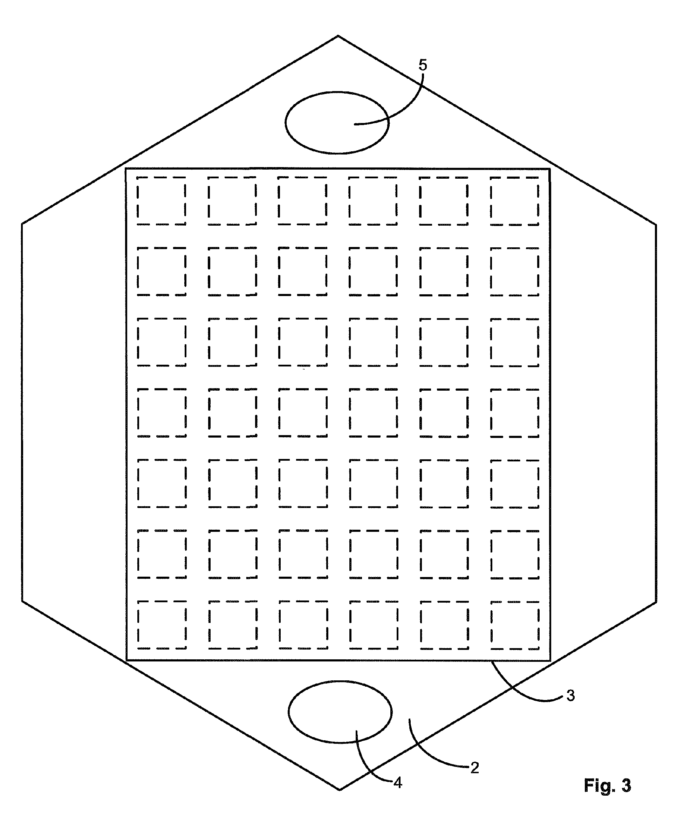

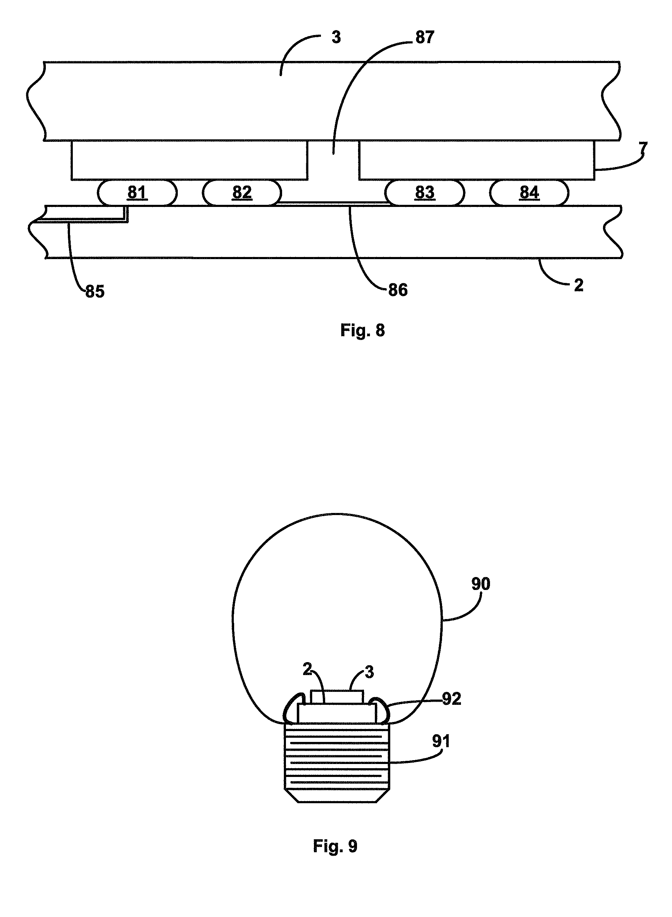

Fig. 3 illustrates the monolithic array of Fig. 1A mounted on a submount. Fig. 8 illustrates a cross section of a portion monolithic array mounted on a submount. Array 3 is flipped over and mounted with the contacts closest to submount 2. The dashed lines illustrate the location of each of the individual LEDs 7. The individual LEDs 7 may be separated by a trench 87 as illustrated in Fig. 8. LED array 3 is mounted on submount 2 by electrically and physically connecting interconnects (such as solder bumps 81-84 of Fig. 8) of each LED 7 to submount 2. LED array 3 is therefore mounted in flip chip configuration, such that light is extracted from each of LEDs 7 through the substrate 15 (Fig. 2). In one embodiment, each of the LEDs are connected to each other in series by interconnects within or on the surface of submount 2. Interconnect 86 of Fig. 8, formed on the surface of submount 2, connects solder bumps 82 and 83 of the two LEDs pictured in Fig. 8. Interconnect 85, formed within submount 2, connects solder bump 81 to another LED or other circuitry (not shown). Alternatively, the individual LEDs can be connected by interconnects formed on array 3. Such interconnects are described in more detail in U.S. Patent No. 6,547,249, issued April 15, 2003, titled "Monolithic Series/Parallel LED Arrays Formed On Highly Resistive Substrates," and incorporated herein by reference. In some embodiments, the individual LEDs in array 3 may be interconnected by a combination of interconnects formed on array 3 and interconnects formed on or within submount 2. In embodiments where all or a portion of the interconnects are formed on array 3, only a portion of the LEDs in array 3 may be electrically and physically connected to submount 3.

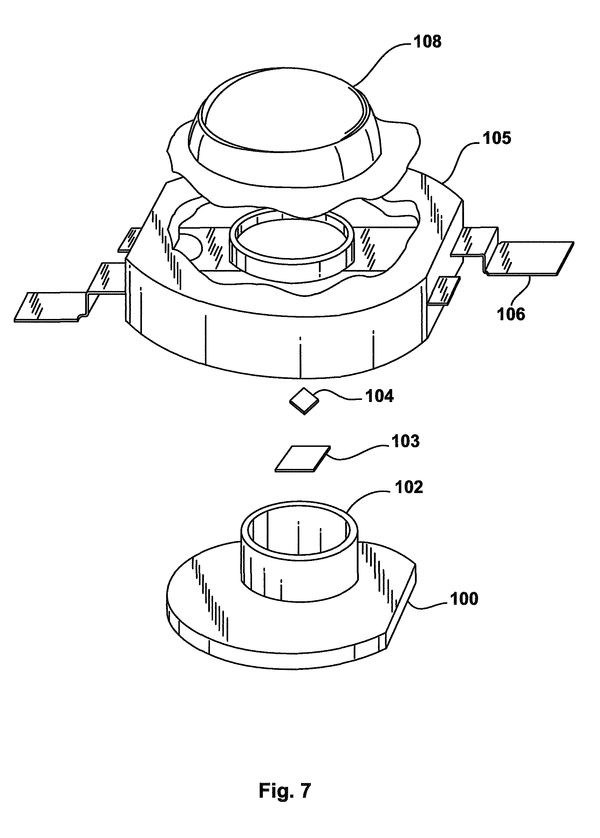

Series interconnection reduces the voltage drop across each LED to a level that does not exceed the maximum forward voltage of each LED. Excessive forward voltage can damage the LEDs irreversibly. Bonding pads 4 and 5 are electrically connected to the positive and negative terminals of the array of LEDs and are used to electrically and physically connect the submount to a package. An example of a package is described below in reference to Fig. 7.

Fig. 3 illustrates a 6 x 7 monolithic array of LEDs mounted on submount 2. The number of LEDs in the monolithic array may be selected to achieve a particular voltage drop across each device. The voltage across each of the individual LEDs in the array is the line voltage divided by the number of LEDs in series. The number of LEDs is chosen such that the maximum voltage across each individual LED during the peak in the alternating current cycle is low enough so as to not damage the LEDs. At 120 RMS volts, the peak voltage will be about 180V. If the individual LEDs illustrated in Figs. 1B and 2 can tolerate a maximum forward voltage of 4.5V, at least 38 LEDs connected in series are required to prevent the voltage across each LED from exceeding the maximum tolerable voltage at the peak of the alternating current cycle. Sources with 240 RMS volts would require twice as many LEDs connected in series, while 60 RMS volt sources would require half as many LEDs connected in series. In some embodiments, the number of LEDs is selected to accommodate common alternating current sources, such as 100V in Japan, 120V in the United States, and 240V in Europe and parts of Asia. For example, for a 120 V alternating current circuit, the peak voltage may be about 180 V. If each of the LEDs in the 6 x 7 array of LEDs illustrated in Fig. 3 has a forward voltage of 3.5 V, each device will achieve the desired current density of 50 A/cm² at 3.5 x 42 = 147 V, without exceeding the maximum current density of 150 A/cm² at the peak voltage of 180 V. In the embodiment illustrated in Fig. 3, a single monolithic array is mounted on a single submount. In some embodiments, more than one monolithic array may be mounted on one or more submounts, in order to achieve the desired maximum voltage drop across each LED in the arrays.

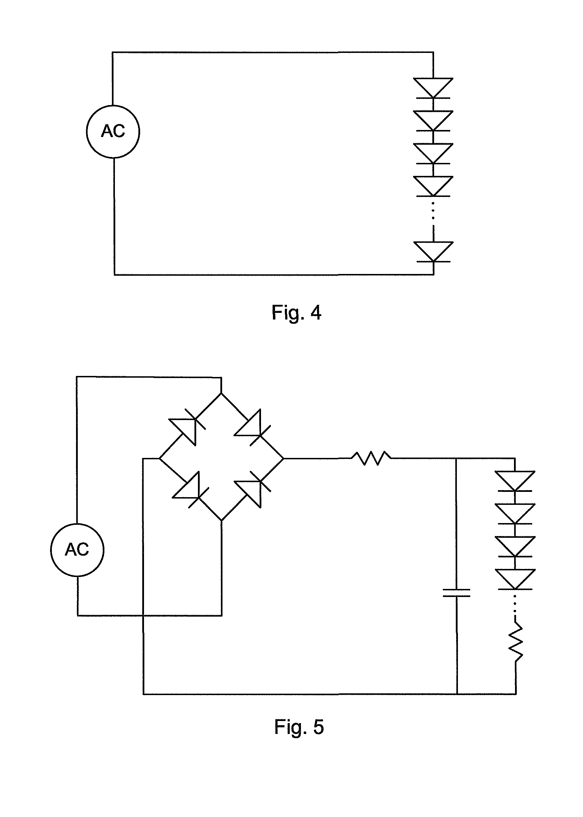

Figs. 4 and 5 illustrate two examples of circuits that may be implemented in the device illustrated in Fig. 3. Fig. 4 illustrates a device with an LED array connected in series with an alternating current source, without any rectifying and filtering circuitry for converting the alternating voltage to a direct voltage. The LEDs are only on during that portion of the positive voltage half of each cycle of the alternating current where there is enough voltage to turn on the LEDs. Thus, at 60 Hz, the LEDs turn on 60 times per second.

Fig. 5 illustrates an LED array and a full wave bridge rectifier for rectifying the alternating current source. The full wave bridge rectifier can be an external component or integrated into the submount, as described below. An optional capacitor filters the rectified voltage to provide nearly direct current to the LED array. Driving the LEDs with a near-direct current source is common and an efficient drive waveform. When the line voltage drops below the turn-on voltage for the LEDs during the alternating current cycle, current is supplied from the capacitor rather than from the line. When the line voltage rises above the turn-on voltage of the LEDs, the capacitor charges. In some embodiments of the invention, rectifying and filtering circuitry, such as the capacitor and full wave bridge rectifier illustrated in Fig. 5, is formed in submount 2 shown in Fig. 3. Submount 2 may be, for example, a silicon chip. The circuitry other than the LED array illustrated in Fig. 5 can be formed on and/or in submount 2 using conventional integrated circuit fabrication techniques.

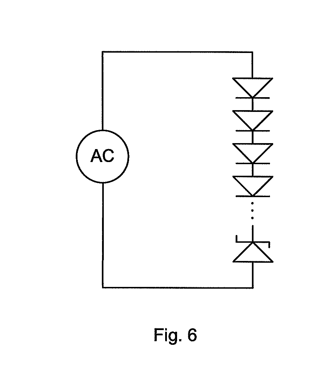

In some embodiments of the devices illustrated in Figs. 4 and 5, one or more Zener diodes may be included in series with the LED array to control the voltage drop across the LED array, as illustrated in Fig. 6. The Zener diodes may be formed in submount 2. In addition, submount 2 may contain additional circuitry such as electrostatic discharge protection circuitry.

Fig. 7 is an exploded view of a packaged light emitting device. A heat-sinking slug 100 is placed into a leadframe 105. The leadframe 105 may be, for example, a filled plastic material molded around a metal frame that provides an electrical path. Slug 100 may include an optional reflector cup 102. The light emitting device array and submount 104, which may be any of the devices described herein, is mounted on slug 100. Bonding pads 4 and 5 on submount 2 (Fig. 3) are electrically connected to leads 106 by, for example wire bonding. An optical lens 108 may be added.

In some embodiments, one or more wavelength converting layers are formed over the LEDs to create white light. For example, blue LEDs may be used with a yellow wavelength converting layer, or with a red wavelength converting layer and a green wavelength converting layer, in order to create white light. Similarly, UV LEDs may be used with red, blue, and green wavelength converting layers to create white light. The wavelength converting layers may be, for example, any suitable phosphors, and may be deposited over each of LEDs 7 in array 3 (Fig. 3) by screen printing or electrophoretic deposition, or suspended in an encapsulant and injected into the space between device 104 and lens 108 in Fig. 7. Individual LEDs in the monolithic array may be covered with different wavelength converting materials.

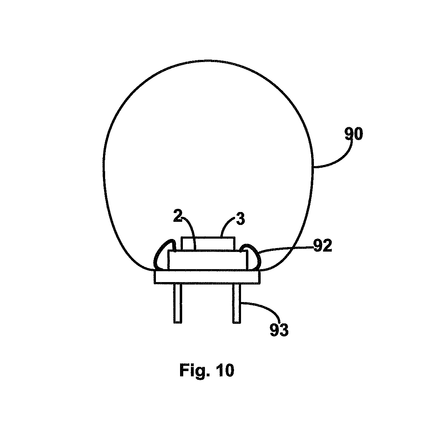

Fig. 9 illustrates a monolithic LED array in a package such as an Edison base, designed to be screwed into a conventional light bulb socket. Submount 2 is connected by wire bonds 92 to the contacts in base 91. Base 91 can be screwed into a conventional light bulb socket. A glass bulb 90 may be positioned over base 91. Fig. 10 illustrates a monolithic LED array in a bi-pin base such as an MR16 base, designed to be plugged into a conventional wall socket. Submount 2 is connected by wire bonds 92 to contacts connected to the two prongs of plug 93. In the devices illustrated in Figs. 9 and 10, any necessary circuitry additional to array 3, such as electrostatic discharge protection circuitry, or rectifying and filtering circuitry, may be formed within submount 2.

Monolithic arrays of LEDs capable of operating with an alternating current source may offer several advantages. First, the use of a single monolithic array on a single submount simplifies building and packaging the device since it is only necessary to align, mount, and connect a single chip to the submount, rather than separate, individual devices. In addition, the lack of rectifying or filtering circuitry (or the integration of rectifying and filtering circuitry into the submount) makes the devices small in size and simple to package, since external driver circuitry is not required. In addition, devices without rectifying and filtering circuitry in particular are simple and inexpensive to fabricate due to the lack of additional circuitry beyond the LED array.

Having described the invention in detail, those skilled in the art will appreciate that, given the present disclosure, modifications may be made to the invention without departing from the spirit of the inventive concept described herein. For example, though some examples describe III-nitride devices, devices made from other materials systems, such as III-phosphide, III-arsenide, or II-VI materials may be used. Therefore, it is not intended that the scope of the invention be limited to the specific embodiments illustrated and described.

## Claims

1. A device comprising:
a submount; and
a plurality of light emitting diodes formed on a single substrate, the plurality of light emitting diodes being mounted on the submount and connected in series;
wherein the plurality of light emitting diodes are directly connected to an alternating current source.

2. The device of claim 1 wherein the plurality of light emitting diodes are connected in series by interconnects formed on a surface of the plurality of light emitting diodes.

3. The device of claim 1 wherein the plurality of light emitting diodes are connected in series by interconnects formed on or in the submount.

4. The device of claim 1 wherein the submount comprises a silicon integrated circuit.

5. The device of claim 1 wherein at least one of the light emitting diodes is a III-nitride light emitting diode.

6. The device of claim 5 wherein the III-nitride light emitting diode comprises a portion of the substrate and a plurality of semiconductor device layers, and wherein the III-nitride light emitting diode is mounted on the submount such that the plurality of semiconductor device layers are closer to the submount than the portion of the substrate.

7. The device of claim 1 further comprising at least one wavelength converting material overlying at least one of the light emitting diodes.

8. The device of claim 7 wherein light emitted from the light emitting diodes mixed with light emitted from the at least one wavelength converting material appears white.

9. The device of claim 1 further comprising:
a plurality of leads electrically connected to the submount; and a lens overlying the plurality of light emitting devices;
wherein the alternating current source is connected to the plurality of leads.

10. The device of claim 1, wherein alternating current source has a peak voltage of at least 100 volts.

11. The device of claim 1, wherein the alternating current source has an rms voltage of at least 120 volts.

12. The device of claim 1, wherein the submount is connected to a base capable of being connected to a light bulb socket.

13. The device of claim 12, wherein the base is an Edison base.

14. The device of claim 1, wherein the submount is connected to a base capable of being connected to an alternating current outlet socket.

15. The device of claim 14, wherein the base is an MR16 base.

16. A device comprising:
a submount; and
a plurality of light emitting diodes formed on a single substrate, the plurality of light emitting diodes being mounted on the submount and connected in series;
a rectifying and filtering circuit formed in the submount and connected to the plurality of light emitting diodes.

17. The device of claim 16 wherein at least one of the light emitting diodes is a III-nitride light emitting diode.

18. The device of claim 17 wherein the III-nitride light emitting diode comprises a portion of the substrate and a plurality of semiconductor device layers, and wherein the III-nitride light emitting diode is mounted on the submount such that the plurality of semiconductor device layers are closer to the submount than the portion of the substrate.

19. The device of claim 16 further comprising at least one wavelength converting material overlying at least one of the light emitting diodes.

20. The device of claim 19 wherein light emitted from the light emitting diodes mixed with light emitted from the at least one wavelength converting material appears white.

21. The device of claim 16 wherein the rectifying and filtering circuit comprises a capacitor.

22. The device of claim 16 wherein the rectifying and filtering circuit comprises a full wave bridge rectifier.

23. A method of operating a light emitting device, the method comprising:
providing a plurality of semiconductor light emitting diodes formed on a single substrate and connected in series; and
supplying an alternating current source to the plurality of semiconductor light emitting diodes.

24. The method of claim 23 wherein the plurality of semiconductor light emitting diodes are physically mounted on and electrically connected to a submount, and supplying an alternating current source to the plurality of semiconductor light emitting diodes comprises supplying an alternating current source to the submount.
